# EUROPEAN PATENT APPLICATION

(11) **EP 4 343 018 A1**
(43) Date of publication of application: **27.03.2024**
(21) Application number: 22804699.1
(22) Date of filing: 17.05.2022
(51) Int. Cl.: C23C 14/34, F04B 37/02, F04B 37/16

(54) **NON-EVAPORABLE-GETTER COATING DEVICE, METHOD FOR MANUFACTURING NON-EVAPORABLE-GETTER-COATED CONTAINER/PIPE, AND NON-EVAPORABLE-GETTER-COATED CONTAINER/PIPE**

(30) Priority: 20.05.2021 JP 2021085612
(71) Applicant: Inter-University Research Institute Corporation High Energy Accelerator Research Organization, Tsukuba-shi Ibaraki 305-0801 (JP); JEOL Ltd., Akishima-shi,, Tokyo 196-8558 (JP)
(72) Inventor: TANIMOTO, Yasunori, Tsukuba-Shi, Ibaraki 305-0801 (JP); OKANO, Makoto, Akishima-Shi, Tokyo 196-8558 (JP)
(74) Representative: Scott, Stephen John
(86) International application number: PCT/JP2022/020595
(87) International publication number: WO 2022/244788

(57) **Abstract**

It would be helpful to provide a non-evaporable getter coating device that can apply non-evaporable getter coating to inner surfaces of vacuum containers or vacuum pipes of various shapes or standards, through the use of the non-evaporable getter coating device being attached to the vacuum containers or vacuum pipes. A non-evaporable getter coating device including a sputter target having an inner space, a permanent magnet column provided within a range of the inner space of the sputter target, the permanent magnet column constituted of a plurality of permanent magnets arranged in series with alternate directions of magnetic fields, and a flange to which the sputter target and the permanent magnet column are secured, wherein the ratio (LM/EDM) of the length LM of each of the permanent magnets to the outer diameter EDM of the permanent magnets is 1.0 to 4.0, and the ratio (EDM/EDN) of the outer diameter EDM of the permanent magnets to the outer diameter EDN of the sputter target is 0.3 to 0.8; a method for manufacturing a non-evaporable getter coated container and/or a non-evaporable getter coated pipe; and a non-evaporable getter coated container and/or a non-evaporable getter coated pipe.

## Description

### TECHNICAL FIELD

This disclosure relates to a non-evaporable getter coating device, a method for manufacturing a non-evaporable getter coated container/pipe, and a non-evaporable getter coated container/pipe.

### BACKGROUND

In the field of vacuum science and technology, non-evaporable getter (hereinafter also referred to as "NEG") pumps with NEGs are attracting attention as vacuum pumps that consume less energy and allow evacuation over wide pressure ranges. The NEG pump is a vacuum pump that cleans a surface of the NEG by heating the NEG in a vacuum and evacuates gas from a vacuum device by absorbing the gas remaining inside the vacuum device to which the non-evaporable getter pump is connected.

As conventionally used NEG coating technology, technology developed around 1997 at the European Organization for Nuclear Research, (CERN) for the purpose of making inner surfaces of beam ducts for particle accelerators function as vacuum pumps, is known (see Patent Literature (PTL) 1, Non-Patent Literature (NPL) 1). In this technology, a Ti-Zr-V thin film with a fine crystalline structure is deposited on an inner surface of a vacuum container using a magnetron sputtering method, which enables high pumping speed and low photo- and electron-stimulated desorption gas emission characteristics at low activation temperatures of 180°C or lower. However, the deposition method of the above technology is specialized for long beam ducts for accelerators. The above technology is based on the technical concept that a sputter target is placed inside the long beam duct for the accelerator along its extension direction, and requires a twisted-wire Ti-Zr-V target and a magnetic field provided by a large solenoid electromagnet.

In semiconductor manufacturing apparatuses and the like, magnetron sputtering technology using permanent magnets is already in practical use. In this technology, a substrate (wafer) and a sputter target are placed opposite for deposition, so a permanent magnet is usually disposed in a position that is behind the sputter target when viewed from the substrate (wafer).

However, the conventional and existing commercialized technology described above has not been able to deposit a film on an inner surface of a vacuum device or vacuum equipment with a complex shape.

Here, enabling to apply non-evaporable getter coating to vacuum devices or vacuum equipment with complex shapes contributes to development in a wide range of fields of industry and research. Therefore, in the field of vacuum science and technology, it would be helpful to develop a small and portable non-evaporable getter coating device that can be incorporated into any vacuum devices or vacuum equipment.

It is understood that in the conventional and existing commercialized technology described above, a sputter target, a duct or substrate to be sputtered, and a magnetic field source are arranged in this order so that the magnetic field source does not interfere with sputtering.

The inventors have arrived at the idea of developing a new non-evaporable getter coating device based on the new technical concept of incorporating a magnetic field source inside a sputter target, instead of placing the magnetic field source outside the sputter target.

It has been reported that a prototype flange-mounted non-evaporable getter coating device has been produced using a Ti-Zr-V alloy as a sputter target and a Sm-Co magnet as a permanent magnet (see NPL 2).

### CITATION LIST

### Patent Literature

PTL 1: WO 1997/049109

### Non-patent Literature

NPL 1: Thin Solid Films, 515, (2006), 382-388
NPL 2: 2019 Academic Lecture Proceedings of the Japan Society of Vacuum and Surface Science, October 29, 2019

### SUMMARY

### (Technical Problem)

However, in the prototype flange-mounted non-evaporable getter coating device described above, magnetron sputtering conditions cannot be obtained, and non-evaporable getter coating cannot be applied to an inner surface of a vacuum container or a vacuum pipe.

It would be helpful to provide a non-evaporable getter coating device that can apply non-evaporable getter coating to inner surfaces of vacuum containers or vacuum pipes of various shapes or standards, through the use of the non-evaporable getter coating device being attached to the vacuum containers or vacuum pipes.

### (Solution to Problem)

The gist of the disclosure is as follows.

A non-evaporable getter coating device according to the disclosure includes:
a sputter target having an inner space;
a permanent magnet column provided within a range of the inner space of the sputter target, the permanent magnet column constituted of a plurality of permanent magnets arranged in series with alternate directions of magnetic fields; and
a flange to which the sputter target and the permanent magnet column are secured,
wherein
the ratio (LM/EDM) of the length LM of each of the permanent magnets to the outer diameter EDM of the permanent magnets is 1.0 to 4.0, and
the ratio (EDM/EDN) of the outer diameter EDM of the permanent magnets to the outer diameter EDN of the sputter target is 0.3 to 0.8.

In the non-evaporable getter coating device according to the disclosure, the sputter target is preferably in the shape of a cylinder, the permanent magnets are preferably in the shape of columns, and the flange is preferably in the shape of a disk.

In the non-evaporable getter coating device according to the disclosure, an extension direction of the sputter target and an extension direction of the permanent magnet column both preferably coincide with a direction perpendicular to a plane of the disk-shaped flange.

In the non-evaporable getter coating device according to the disclosure, a material of the sputter target preferably includes at least one selected from groups consisting of Ti-Zr-V alloys, Ti-Zr-V-Hf alloys, pure Ti, pure Zr, and pure Pd.

In the non-evaporable getter coating device according to the disclosure, the permanent magnets preferably include at least one selected from groups consisting of Sm-Co magnets, Nd-Fe-B magnets, Al-Ni-Co magnets, Pr-Co magnets, and ferrite magnets.

In the non-evaporable getter coating device according to the disclosure, the flange is preferably at least one selected from groups consisting of ICF standard products, NW standard products, ISO standard products, JIS standard products, various metal O-ring sealed products, and various metal gasket sealed products.

In the non-evaporable getter coating device according to the disclosure, the length LM of each of the permanent magnets is preferably 5 mm to 100 mm, the outer diameter EDM of the permanent magnets is preferably 5 mm to 32 mm, and the outer diameter EDN of the sputter target is preferably 16 mm to 80 mm.

The non-evaporable getter coating device according to the disclosure preferably further includes a shield provided so as to cover a securing portion between the sputter target and the flange.

In the non-evaporable getter coating device according to the disclosure, a material of the shield preferably includes polyimide resin.

The non-evaporable getter coating device according to the disclosure preferably further includes a device configured to displace the permanent magnet column to an extension direction.

A method for manufacturing a non-evaporable getter coated container and/or a non-evaporable getter coated pipe according to the disclosure includes:
attaching the non-evaporable getter coating device according to the disclosure to a vacuum pipe and/or a vacuum container; and
forming a non-evaporable getter material layer on an inner surface of the vacuum container and/or the vacuum pipe by a magnetron sputtering method to obtain a non-evaporable getter coated container and/or a non-evaporable getter coated pipe.

In the method for manufacturing a non-evaporable getter coated container and/or a non-evaporable getter coated pipe according to the disclosure, a discharge gas in the magnetron sputtering method is preferably Kr or Ar.

In the method for manufacturing a non-evaporable getter coated container and/or a non-evaporable getter coated pipe according to the disclosure, the pressure of a discharge gas is preferably 0.05 Pa to 30 Pa.

In the method for manufacturing a non-evaporable getter coated container and/or a non-evaporable getter coated pipe according to the disclosure, a cathode voltage in the magnetron sputtering method is preferably -1000 V to -300 V.

In the method for manufacturing a non-evaporable getter coated container and/or a non-evaporable getter coated pipe according to the disclosure, the non-evaporable getter coated pipe and/or the non-evaporable getter coated container is preferably shaped with a bent portion.

In the method for manufacturing a non-evaporable getter coated container and/or a non-evaporable getter coated pipe according to the disclosure, the inner diameter of the vacuum container and/or the vacuum pipe is preferably 20 mm to 200 mm.

A non-evaporable getter coated container and/or a non-evaporable getter coated pipe according to the disclosure includes a bent portion in shape, wherein the average grain diameter of crystals of a coated non-evaporable getter is 2 nm to 100 nm.

### (Advantageous Effect)

According to the disclosure, it is possible to provide a non-evaporable getter coating device that can apply non-evaporable getter coating to inner surfaces of vacuum containers or vacuum pipes of various shapes or standards, through the use of the non-evaporable getter coating device being attached to the vacuum containers or vacuum pipes.

### BRIEF DESCRIPTION OF THE DRAWINGS

In the accompanying drawings:

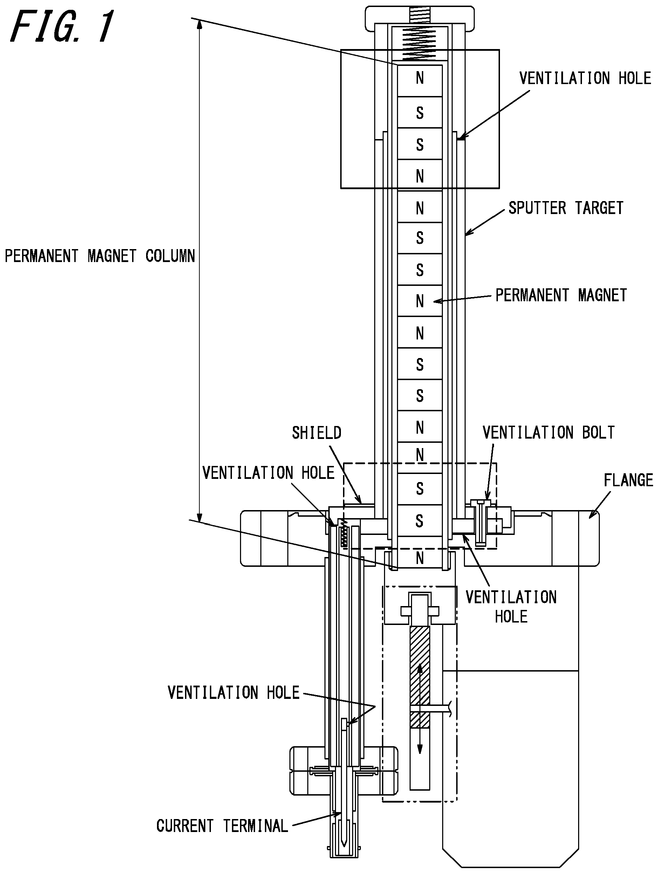

FIG. 1 is a cross-sectional view of a non-evaporable getter coating device according to an embodiment of the disclosure, when cut by a plane along its extension direction;

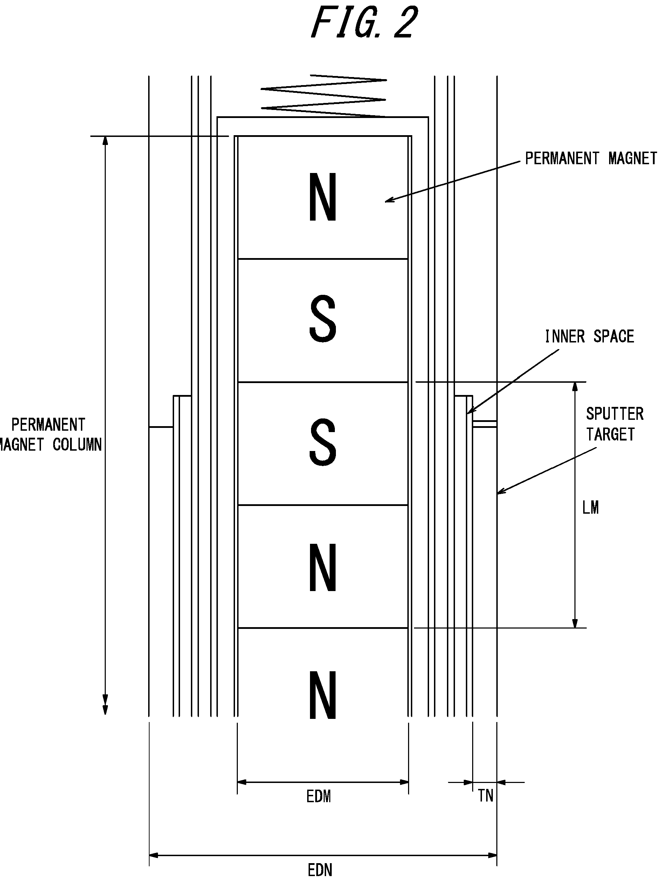

FIG. 2 is an enlarged view of a part (part indicated by the solid rectangular frame in FIG. 1) of the non-evaporable getter coating device according to the embodiment of the disclosure illustrated in FIG. 1;

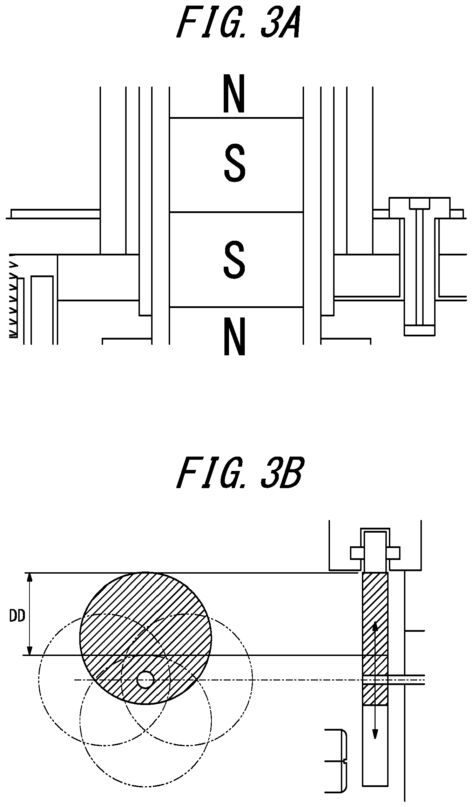

FIG. 3A is an enlarged view of a part (part indicated by the dashed rectangular frame in FIG. 1) of the non-evaporable getter coating device according to the embodiment of the disclosure illustrated in FIG. 1;
FIG. 3B is an enlarged view of a part (part indicated by the double-dashed rectangular frame in FIG. 1) of the non-evaporable getter coating device according to the embodiment of the disclosure illustrated in FIG. 1 (the right figure is a cross-sectional view by plane in FIG. 1, and the left figure is a cross-sectional view by plane perpendicular to the plane in FIG. 1);

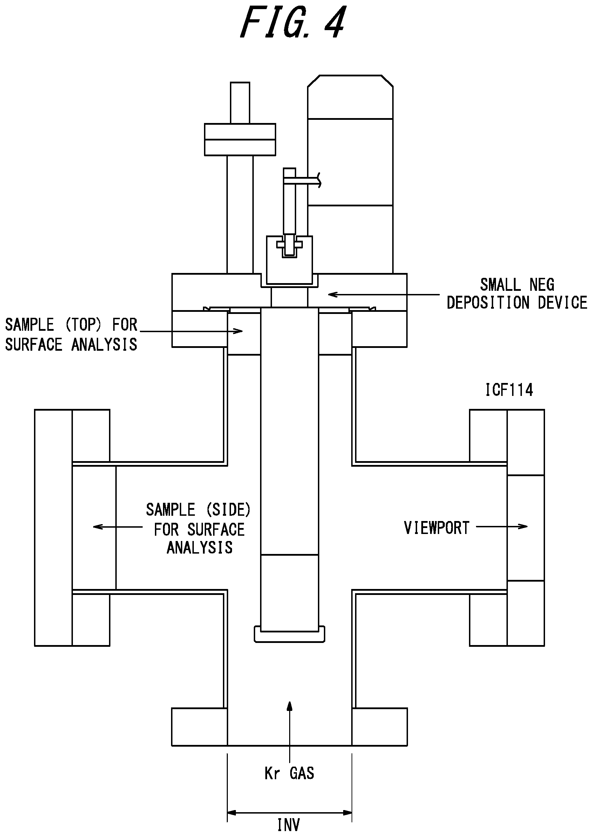

FIG. 4 is a diagram schematically illustrating a state in a test in which a non-evaporable getter coating device of Example 1 of the disclosure was attached to a cross tube and a non-evaporable getter material layer was formed on an inner surface of the cross tube by a magnetron sputtering method;

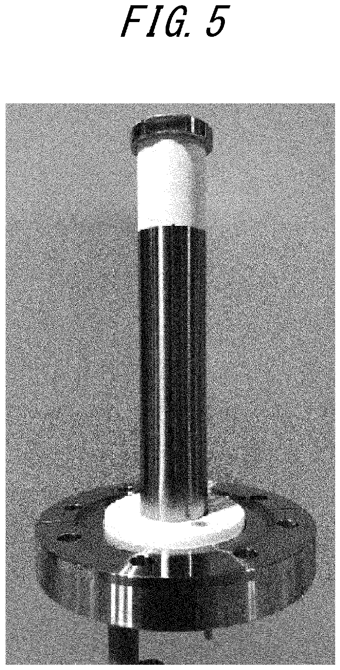

FIG. 5 is a photograph (perspective view) of an ICF114-standard non-evaporable getter coating device of Example 1;

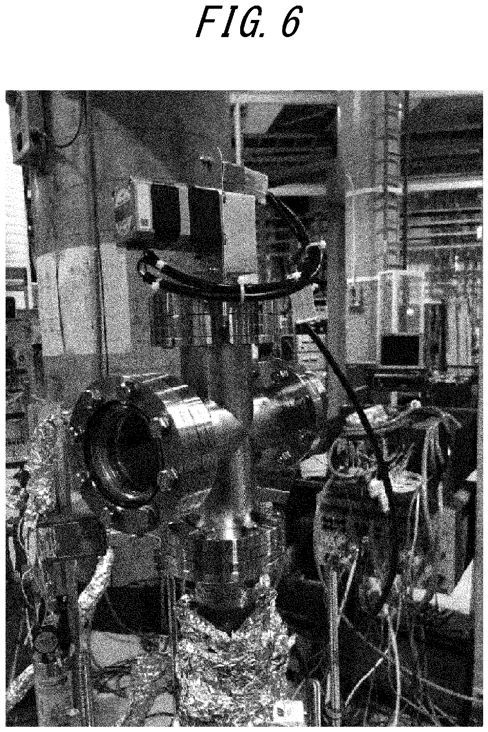

FIG. 6 is a photograph (perspective view) of a state in the test in which the ICF114-standard non-evaporable getter coating device of Example 1 was attached to an ICF114-standard cross tube and a non-evaporable getter material layer was formed on an inner surface of the cross tube by the magnetron sputtering method;

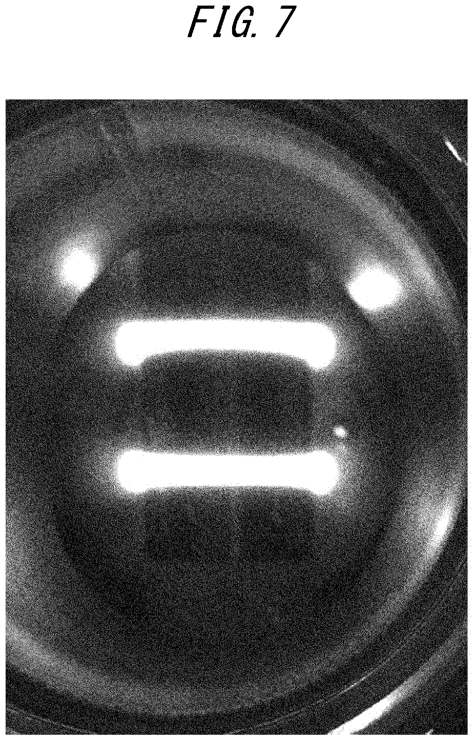

FIG. 7 is a photograph, taken from a viewport, of a state in the test in which the ICF114-standard non-evaporable getter coating device of Example 1 was attached to the ICF114-standard cross tube and the non-evaporable getter material layer was formed on the inner surface of the cross tube by the magnetron sputtering method under the conditions of Example 1;

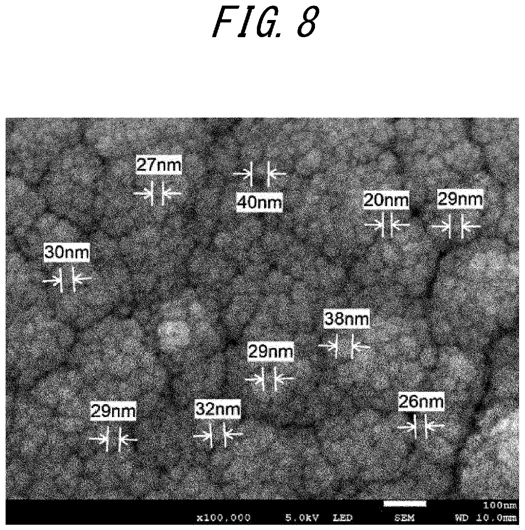

FIG. 8 is a photograph, taken by a SEM, of the inner surface of the non-evaporable getter coated cross tube obtained when the test in which the ICF114-standard non-evaporable getter coating device of Example 1 was attached to the ICF114-standard cross tube and the non-evaporable getter material layer was formed on the inner surface of the cross tube by the magnetron sputtering method under the conditions of Example 1 was conducted; and

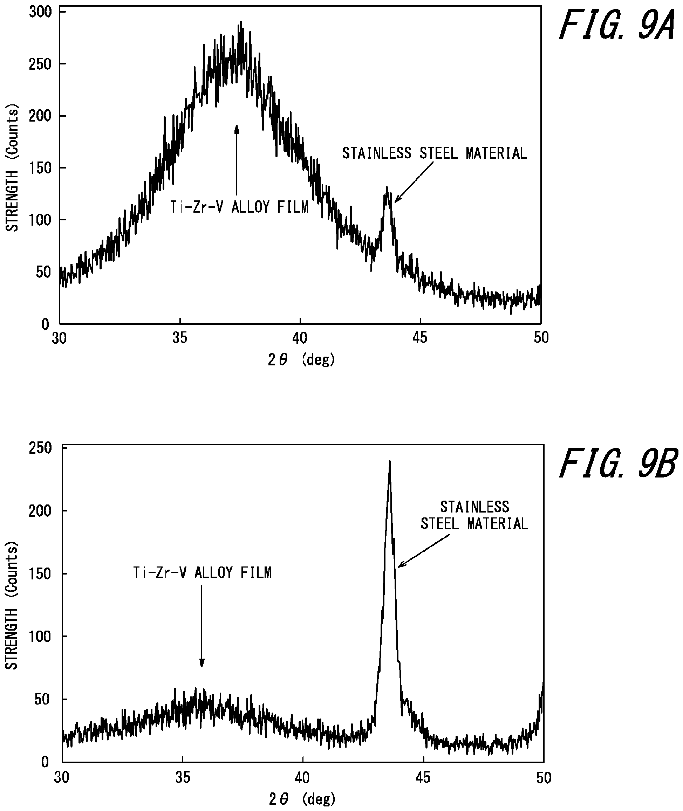

FIGS. 9A and 9B are charts that indicate results of XRD measurements of stainless steel samples disposed on the inner surface of the cross tube when the test in which the ICF 114-standard non-evaporable getter coating device of Example 1 was attached to the ICF114-standard cross tube and the non-evaporable getter material layer was formed on the inner surface of the cross tube by the magnetron sputtering method under the conditions of Example 1 was conducted, FIG. 9A indicates the result of the XRD measurement on the stainless steel sample (Top) for monitoring, and FIG. 9B indicates the result of the XRD measurement on the stainless steel sample (Side) for monitoring.

### DETAILED DESCRIPTION

A non-evaporable getter coating device, a method for manufacturing a non-evaporable getter coated container and/or a non-evaporable getter coated pipe, and a non-evaporable getter coated container and/or a non-evaporable getter coated pipe according to an embodiment of the disclosure (hereinafter referred to as "present embodiment") will be exemplarily described below in detail with reference to the drawings.

In the specification of this application, "A to B" with respect to a numerical value range means is A or more and B or less. An inner diameter and an outer diameter both mean diameters.

### (Non-evaporable Getter Coating Device)

The non-evaporable getter coating device according to the present embodiment includes a sputter target having an inner space, a permanent magnet column that is provided within a range of the inner space of the sputter target and constituted of a plurality of permanent magnets arranged in series with alternate directions of magnetic fields, and a flange to which the sputter target and the permanent magnet column are secured.

The inner space of the sputter target means a space enclosed by the sputter target, specifically, when inner and outer surfaces of the sputter target can be conceived of in terms of shape, a space defined by the inner surface of the sputter target, and more specifically, when an opening of the sputter target can be conceived of in terms of shape, a space defined by the inner surface and a surface formed by an edge of the opening.

In the present embodiment, at least a part of the permanent magnet column should be provided within the range of the inner space of the sputter target. It is preferable that 50 volume% or more, 70 volume% or more, or 90 volume% or more of the permanent magnet column be within the range of the inner space of the sputter target.

Furthermore, in the present embodiment, the sputter target may be constituted of a single component or a combination of two or more components.

FIG. 1 is a cross-sectional view of the non-evaporable getter coating device according to the embodiment of the disclosure when cut by a plane along its extension direction.

Specifically, in the non-evaporable getter coating device according to the present embodiment illustrated in FIG. 1, the sputter target and the permanent magnet column are secured to a flange by fitting the sputter target and the permanent magnet column into the flange.

These members may be secured by an ordinary method through an insulating member or by bolts or the like.

The permanent magnet column in the non-evaporable getter coating device according to the present embodiment illustrated in FIG. 1 is constituted of the plurality of permanent magnets arranged in series with the alternate directions of the magnetic fields, i.e., so that a direction from the S pole to the N pole in a magnet coincides with a direction from the N pole to the S pole in a magnet adjacent to the magnet.

In the present embodiment, it is preferable to use the plurality of permanent magnets of the same size, from the viewpoint of adjusting periodic plasma.

The adjacent permanent magnets may be arranged in direct contact or at predetermined intervals, but from the viewpoint of obtaining a stable periodic magnetic field, it is preferable that the adjacent permanent magnets be arranged in direct contact.

In the non-evaporable getter coating device according to the present embodiment illustrated in FIG. 1, the sputter target is in the shape of a cylinder, the permanent magnet is in the shape of a column, and the flange is in the shape of a disk.

In the non-evaporable getter coating device according to the disclosure, the shapes are not limited to the above-described shapes according to the present embodiment. The sputter target is preferably in the shape of a cylinder, but is not particularly limited in shape as long as the sputter target has an inner space, and may be in the shape of a tube other than a cylinder (e.g., the shape of a tube with a square bottom), a box, a container, or the like. The permanent magnet is preferably in the shape of a column, but may be in the shape of a pillar other than a column (e.g., the shape of a pillar with a square bottom) or any other shape. The flange is preferably in the shape of a disk, but may be in the shape of a plate with a square bottom or any other shape.

In the non-evaporable getter coating device according to the present embodiment illustrated in FIG. 1, an extension direction of the sputter target and an extension direction of the permanent magnet column both coincide with a direction perpendicular to a plane of the disk-shaped flange.

More specifically, as illustrated in FIG. 1, an axial direction of the cylindrical sputter target and an axial direction of the columnar permanent magnets coincide with a direction perpendicular to a circular top surface of the disk-shaped flange. As illustrated in FIG. 1, an axis of the sputter target, an axis of the permanent magnets, and an axis of the flange coincide with each other.

The non-evaporable getter coating device according to the disclosure is not limited to the arrangement relationship in the present embodiment described above. The extension direction of the sputter target, the extension direction of the permanent magnet column, and the direction perpendicular to the plane of the disk-shaped flange may intersect each other at an angle. The intersection angle in any two of the above three directions is not particularly limited, but may be more than 0° and less than or equal to 45°, or more than 0° and less than or equal to 30°, in order to facilitate obtaining the effects of the disclosure.

In the non-evaporable getter coating device according to the disclosure, as in the device illustrated in FIG. 1, it is preferable that all of the sputter target, the permanent magnet column, and the flange have three-dimensional shapes symmetrical with respect to an axis of rotation.

Here, in the non-evaporable getter coating device according to the present embodiment, the ratio (LM/EDM) of the length LM of the permanent magnet to the outer diameter EDM of the permanent magnet is 1.0 to 4.0.

By setting the lower limit of the ratio ratio (LM/EDM) to 1.0 or more, a magnetic flux density can be distributed to the extent of satisfying magnetron sputtering conditions at a point far from a surface of the sputter target. By setting the upper limit to 4.0 or less, a magnetic flux density can be increased in the vicinity of the surface of the sputter target to the extent of satisfying the magnetron sputtering conditions.

The single permanent magnet in the present embodiment may be constituted of a plurality of small permanent magnets connected in series. In this case, the length LM of the permanent magnet in the device is the sum of the lengths of the plurality of small permanent magnets connected in series.

In the non-evaporable getter coating device according to the present embodiment, the ratio (EDM/EDN) of the outer diameter EDM of the permanent magnet to the outer diameter EDN of the sputter target is 0.3 to 0.8.

By setting the lower limit of the ratio (EDM/EDN) to 0.3 or more, a magnetic flux density can be increased in the vicinity of the surface of the sputter target to the extent of satisfying the magnetron sputtering conditions. By setting the upper limit to 0.8 or less, the magnet column that satisfies the magnetron sputtering conditions can be contained in the inner space of the sputter target.

In order to establish the magnetron sputtering conditions, which are important for non-evaporable getter coating, it is necessary to obtain a magnetic flux density (approximately 250 Gauss or more) of a certain extent or more in the vicinity of the surface of the sputter target.

According to the common general technical knowledge in the art at the time of the filing of this application, it is easy to predict whether a plasma state suitable for sputtering can be obtained in a uniform magnetic field such as those used in PTL 1 and NPL 1. However, it is difficult to predict whether a plasma state suitable for sputtering can be obtained in a periodic magnetic field formed using a permanent magnet column, as in the present embodiment. In particular, since the confinement effect of plasma particles by a mirror magnetic field in a region in which magnetic field lines change three-dimensionally also depends on shape factors, it has been difficult to make effective prediction by simply focusing on the value of a magnetic flux density in the vicinity of a permanent magnet.

In the present embodiment, by setting two shape factors related to the non-evaporable getter coating device, that is, the ratio (LM/EDM) of the length LM of the permanent magnet to the outer diameter EDM of the permanent magnet and the ratio (EDM/EDN) of the outer diameter EDM of the permanent magnet to the outer diameter EDN of the sputter target, within specified ranges, the magnetron sputtering conditions are successfully established in a periodic magnetic field. The ratio (LM/EDM) is a value that can be correlated to the rate of decay of a magnetic flux density with respect to a distance from a permanent magnet. The ratio (EDM/EDN) is a value that can be correlated to the magnitude of a magnetic flux density at a surface of a sputter target.

In the present embodiment, from the viewpoint of facilitating obtaining the effects of the disclosure, the lower limit of the above ratio (LM/EDM) may be 1.2 or more, or 1.4 or more, and the upper limit may be 3.5 or less, or 3.0 or less.

From the viewpoint of facilitating obtaining the effects of the disclosure, the lower limit of the above ratio (EDM/EDN) may be 0.35 or more, or 0.4 or more, and the upper limit may be 0.7 or less, or 0.6 or less.

FIG. 2 is an enlarged view of a part (part indicated by the solid rectangular frame in FIG. 1) of the non-evaporable getter coating device according to the embodiment of the disclosure illustrated in FIG. 1.

In the present embodiment, the length LM of the permanent magnet may be 5 mm to 100 mm. The lower limit may be 8 mm or more, or 15 mm or more. The upper limit may be 60 mm or less, or 40 mm or less.

In the present embodiment, the outer diameter EDM of the permanent magnet may be 5 mm to 32 mm. The lower limit may be 8 mm or more, or 12 mm or more. The upper limit may be 24 mm or less, or 16 mm or less.

In the present embodiment, the outer diameter EDN of the sputter target may be 16 mm to 80 mm. The lower limit may be 20 mm or more, or 24 mm or more. The upper limit may be 60 mm or less, or 40 mm or less.

Here, the non-evaporable getter coating device of the present embodiment illustrated in FIG. 1 further includes a shield that is provided to cover a securing portion between the sputter target and the flange.

As the sputter target deposits on a surface of the securing portion during deposition, the insulation of the securing portion deteriorates, and the stability of electric discharge also decreases. By using the shield, such deterioration and decrease can be prevented or controlled, thereby extending the life of the securing portion and the entire device.

A material of the shield may be an insulating material. The insulating material includes polyimide resin and various machinable ceramics (Photoveel^{®} (Photoveel is a registered trademark in Japan, other countries, or both), Macor^{®} (Macor is a registered trademark in Japan, other countries, or both), and the like), although there are no limitations. Among these, polyimide resin is preferable from the viewpoint of high strength, low gas emission properties, high heat resistance, high corrosion resistance, and high processability into film form.

These may be used alone or in combination of two or more types.

FIG. 3A is an enlarged view of a part (part indicated by the dashed rectangular frame in FIG. 1) of the non-evaporable getter coating device according to the embodiment of the disclosure illustrated in FIG. 1.

The non-evaporable getter coating device according to the present embodiment illustrated in FIG. 1 further includes a device for rotating a cam, as illustrated in FIG. 3B. Here, the cam may be rotated using a low-speed motor or the like.

In the non-evaporable getter coating device of the present embodiment, since plasma is periodically generated along the extension direction of the permanent magnet column, the sputter target is periodically consumed with respect to its extension direction. Thus, by changing the positional relationship of the sputter target with respect to the extension direction of the permanent magnet column by using the above device, the consumption of the sputter target can be averaged in its extension direction.

In the non-evaporable getter coating device according to the disclosure, the device is not limited to the device illustrated in FIG. 3B, but may be a device that displaces the permanent magnet column with respect to its extension direction, and may preferably be a device that enables periodic vertical displacement. The distance DD of vertical displacement is not particularly limited, but when the plurality of permanent magnets of the same size is used, it is preferable that the distance DD be the same as the length LM of each of the permanent magnets from the viewpoint of achieving uniformity of consumption as described above.

FIG. 3B is an enlarged view of a part (part indicated by the double-dashed rectangular frame in FIG. 1) of the non-evaporable getter coating device according to the embodiment of the disclosure illustrated in FIG. 1 (the right figure is a cross-sectional view by plane in FIG. 1, and the left figure is a cross-sectional view by plane perpendicular to the plane in FIG. 1).

In the non-evaporable getter coating device according to the present embodiment, from the viewpoint of further improving evacuation performance and realizing ultra-high vacuum applications, the insulating member of the securing portion may be provided with ventilation holes or grooves (labyrinth structure) as appropriate. In addition, ventilation bolts may be used as the bolts for the securing portion.

A material of the sputter target is not limited and may be selected according to the application and purpose. The material of the sputter target includes Ti-Zr-V alloys, Ti-Zr-V-Hf alloys, pure Ti, pure Zr, pure Pd, and the like. Among these, Ti-Zr-V alloys are preferable in terms of high vacuum evacuation performance, low activation temperature, and low electron- and photo-stimulated desorption characteristics.

These may be used alone or in combination of two or more types.

The permanent magnets that can be used in the present embodiment are not particularly limited and may be selected according to the application and purpose. The permanent magnets include Sm-Co magnets, Nd-Fe-B magnets, Al-Ni-Co magnets, Pr-Co magnets, ferrite magnets, and the like. Among these, Sm-Co magnets are preferable in terms of high magnetic properties and high Curie temperature.

These may be used alone or in combination of two or more types.

The flange that can be used in the present embodiment is not particularly limited, but may be selected according to the standards of a vacuum pipe and/or a vacuum container to be subjected to the non-evaporable getter coating using the non-evaporable getter coating device of the present embodiment. The flange includes, for example, ICF standard products, NW standard products, ISO standard products, JIS standard products, various metal O-ring sealed products, various metal gasket sealed products, and the like.

These may be used alone or in combination of two or more types.

A material of the flange is not particularly limited, but includes stainless steel, oxygen-free copper, copper alloys, aluminum alloys, titanium alloys, ceramics, and the like. Among these, stainless steel is preferable from the viewpoint of its high mechanical strength, heat resistance, and versatility.

These may be used alone or in combination of two or more types.

As illustrated in FIG. 1, the non-evaporable getter coating device according to the present embodiment further includes a current terminal electrically connected to the sputter target to provide an electrical potential between the sputter target and a vacuum container or a vacuum pipe to be subjected to the non-evaporable getter coating by sputtering.

### (Method for Manufacturing Non-evaporable Getter Coated Container and/or Non-evaporable Getter Coated Pipe)

A method for manufacturing a non-evaporable getter coated container and/or a non-evaporable getter coated pipe according to the present embodiment includes attaching the non-evaporable getter coating device according to the present embodiment to a vacuum pipe and/or a vacuum container, and forming a non-evaporable getter material layer on an inner surface of the vacuum container and/or the vacuum pipe by a magnetron sputtering method to obtain a non-evaporable getter coated container and/or a non-evaporable getter coated pipe.

FIG. 4 is a diagram schematically illustrating a state in a test in which a non-evaporable getter coating device of Example 1 of the disclosure is attached to a cross tube and a non-evaporable getter material layer is formed on an inner surface of the cross tube by a magnetron sputtering method.

The vacuum pipe and/or the vacuum container that can be used in the method of the present embodiment are/is not particularly limited, but may be selected as appropriate according to the purpose or application. The vacuum pipe and/or the vacuum container include/includes ICF standard products, NW standard products, ISO standard products, JIS standard products, various metal O-ring sealed products, various metal gasket sealed products, and the like.

These may be used alone or in combination of two or more types.

In the method according to the present embodiment illustrated in FIG. 4, the vacuum pipe to be used is shaped with bent portions.

More specifically, the shape of the vacuum pipe illustrated in FIG. 4 has, with respect to external appearance, bent portions, which are bent with respect to a flow direction, and also has, with respect to an inner space, bent portions, which are bent with respect to the flow direction, in accordance with the external appearance.

By using the vacuum pipe or the vacuum container shaped with such bent portions, it is possible to advantageously demonstrate the features of the non-evaporable getter coating device of the present embodiment.

In the method of the disclosure, the shape of the vacuum container and/or the vacuum pipe to be used is not particularly limited.

Preferable examples of the vacuum pipe shaped with the bent portions include cross tubes, elbow tubes, tees tubes, hexagonal tubes, flexible tubes, and the like.

Preferable examples of the vacuum container shaped with the bent portion include manifold tubes, branch tubes incorporated in vacuum devices (such as electron microscopes, particle accelerators, analyzers, and semiconductor manufacturing apparatuses), and the like.

These may be used alone or in combination of two or more types.

Materials of the vacuum pipe and the vacuum container are not particularly limited, but include stainless steel, oxygen-free copper, copper alloys, aluminum alloys, titanium alloys, ceramics, and the like. Among these, stainless steel is preferable from the viewpoint of high mechanical strength, heat resistance, and versatility.

These may be used alone or in combination of two or more types.

The inner diameter of the vacuum container and/or the vacuum pipe to be used in the method of the present embodiment is not particularly limited, but from the viewpoint of ease of deposition, is preferably 20 mm to 200 mm. The lower limit may be 30 mm or more, and the upper limit may be 100 mm or less.

The thickness of the vacuum container and/or the vacuum pipe to be used in the method of the present embodiment is not particularly limited, but may be 0.3 mm to 6 mm. It is preferable that the thickness should be constant over most of the vacuum container and/or the vacuum pipe.

Preferable conditions will be hereinafter described.

A discharge gas in the magnetron sputtering method in the method of the present embodiment may be a noble gas. From the viewpoint of high sputtering efficiency and difficulty of embedding in a film, the discharge gas is preferably Kr or Ar, and especially preferably Kr.

These may be used alone, or in combination with two or more types.

The pressure of the above-described discharge gas is preferably 0.05 Pa to 30 Pa from the viewpoint of stable plasma generation and control of film quality and deposition speed. The lower limit may be 0.1 Pa or more, and the upper limit may be 3 Pa or less.

A cathode voltage in the magnetron sputtering method in the method of the present embodiment is preferably -1000 V to -300 V from the viewpoint of high sputtering efficiency and control of film quality and deposition speed. The lower limit may be -600 V or more, and the upper limit may be -350 V or less.

### (Non-evaporable Getter Coated Container and/or Non-evaporable Getter Coated Pipe)

The non-evaporable getter coated container and/or the non-evaporable getter coated pipe according to the present embodiment are/is shaped with bend portions.

In the non-evaporable getter coated container and/or the non-evaporable getter coated pipe according to the present embodiment, the average grain size of crystals of the non-evaporable getter coated is 2 nm to 100 nm.

The average grain size of the crystals of the non-evaporable getter refers to an average value when the maximum diameters of 10 portions, which are surrounded and granular by dark boundaries that appear to be crystal grain boundaries in an image photographed by a SEM, are measured.

An average grain size of 2 nm or more enables film growth with a columnar structure suitable for internal diffusion of surface adsorbed gas. An average grain size of 100 nm or less enables the activation of the non-evaporable getter at relatively low temperatures (e.g., 180°C).

The lower limit of the above average grain size may be 10 nm or more, or 20 nm or more, and the upper limit may be 50 nm or less, or especially preferably 30 nm or less.

The above average grain size can be adjusted larger by keeping the temperature of the vacuum pipe or the vacuum container high or the pressure of the discharge gas low during a manufacturing stage, and smaller by keeping the temperature of the vacuum pipe or the vacuum container low or the pressure of the discharge gas high during the manufacturing stage.

The embodiment of the non-evaporable getter coating device, the method for manufacturing a non-evaporable getter coated container and/or a non-evaporable getter coated pipe, and the non-evaporable getter coated container and/or the non-evaporable getter coated pipe according to the disclosure are exemplarily described above with reference to the drawings. However, the above embodiment is changeable as appropriate, and the disclosure is not limited to the above exemplary embodiment.

### EXAMPLES

The disclosure will be described in more detail below by way of examples, but the disclosure is not limited to the following examples.

### (Example 1)

An ICF114-standard non-evaporable getter coating device was manufactured according to the following procedure.

An ICF114-standard disk-shaped flange made of stainless steel (dimensions: length (thickness) 17.5 mm, outer diameter 114 mm) was prepared.

As a sputter target, a cylindrical Ti-Zr-V alloy (dimensions: length 120 mm, inner diameter 20 mm, outer diameter 28 mm) was prepared.

Columnar Sm-Co magnets (dimensions: length 20.0 mm, outer diameter 13.5 mm) were prepared as permanent magnets, and eight of the Sm-Co magnets were arranged in series with alternate directions of magnetic fields to manufacture a permanent magnet column.

The permanent magnet column was inserted into an inner space of the sputter target, and the sputter target and the permanent magnet column were secured to the flange by fitting the sputter target and the permanent magnet column into the flange. At this time, these components were arranged so that an axis of the sputter target, an axis of the permanent magnets, and an axis of the flange were aligned. Photoveel^{®} was used as an insulating material for a securing portion. The insulating member was provided with ventilation holes and grooves (labyrinth structure). In addition, ventilation bolts were used in the securing portion.

A current terminal (product name C34SHR1 manufactured by Cosmotec Co., Ltd.) was connected to the sputter target.

Materials, dimensions, and the like are listed in Table 1.

FIG. 5 is a photograph (perspective view) of the ICF114-standard non-evaporable getter coating device in Example 1.

As a vacuum pipe, an ICF114-standard cross tube made of stainless steel (dimensions: length in one direction 210 mm, length in another crosswise direction 210 mm, inner diameter 60 mm, outer diameter 64 mm) was prepared.

The manufactured non-evaporable getter coating device of Example 1 was attached to a first opening of the cross tube from above to below (see FIG. 4). A stainless steel sample (Top) for monitoring (dimensions: 0.15 mm thick, 20 mm long, 170 mm wide) was disposed on the securing portion of the device.

A second opening of the cross tube located at the bottom was used as an Kr gas inlet.

A third opening of the cross tube located on a side was sealed with an appropriate material, and a stainless steel sample (Side) for monitoring (dimensions: 0.15 mm thick, 20 mm long, 170 mm wide) was disposed on an inner surface of this material.

A fourth opening of the cross tube located on the other side was sealed with a member with a viewport.

Then, an electrical potential was applied between the sputter target and the cross tube for 360 minutes under the conditions listed in Table 1.

FIG. 4 is a diagram schematically illustrating a state in the test in which the non-evaporable getter coating device of Example 1 of the disclosure was attached to the cross tube and a non-evaporable getter material layer was formed on an inner surface of the cross tube by a magnetron sputtering method.

At 3 minutes after the start of current introduction, a surface of the sputter target was observed from the viewport for the electrical potential, and whether magnetron sputtering conditions were established was determined based on whether plasma emission, which was periodically repeated at intervals corresponding to the length of the permanent magnets, was clearly generated.

In Example 1, the magnetron sputtering conditions were determined as being established.

A maximum electron density (m⁻³) was calculated using plasma analysis software Particle-PLUS under the conditions listed in Table 1.

To determine a magnetic flux density (Gauss) at the surface of the sputter target, a magnetic field distribution and a maximum flux density were measured by scanning the surface of the target with a Gauss meter.

The samples were collected at the point of 360 minutes after the start of current introduction, and whether the non-evaporable getter material layer was formed on the surfaces of the samples was determined by XRD measurement.

Measurement conditions were as follows.

An XRD measurement device (product name MultiFlex manufactured by Rigaku Corporation) was used.

The sample (Top) and the sample (Side) were secured to a sample holder.

A test anode was placed at the center of the sample holder.

The range of 20=30° to 50° was divided into 0.02° steps, and each step was measured in 0.4 seconds.

As an X-ray source, a Kα1 beam of Cu was used.

A voltage and a current of the X-ray source were 48 kV and 40 mA, respectively.

A divergence slit of 1° was used.

A scintillation counter was used as a detector.

At the point of 360 minutes after the start of current introduction, the samples were collected, and the details of the non-evaporable getter coating were measured.

The thickness (µm) of the coating was measured by cross-sectional SEM observation.

A deposition speed (nm/hour) was calculated by dividing the thickness of the coating by the time from the start of current introduction until the samples were collected.

The surfaces of the samples were photographed with an SEM system (product name JSM-7200F manufactured by JEOL Ltd.). In each SEM image, 10 portions were arbitrarily selected as granular portions surrounded by dark boundaries that appeared to be crystal grain boundaries. The maximum diameter of each portion was read from the image. The read 10 maximum diameters (nm) were averaged to obtain the average grain size (nm) of the non-evaporable getter coating of the sample.

The conditions and results for each of the above tests are listed in Table 1.

FIG. 6 is a photograph (perspective view) of a state in the test in which the ICF114-standard non-evaporable getter coating device of Example 1 was attached to the ICF114-standard cross tube and the non-evaporable getter material layer was formed on the inner surface of the cross tube by the magnetron sputtering method.

In FIG. 6, a part located in the foreground is a part at which the opening was sealed with the member with the viewport.

FIG. 7 is a photograph, taken from the viewport, of a state in the test in which the ICF114-standard non-evaporable getter coating device of Example 1 was attached to the ICF114-standard cross tube and the non-evaporable getter material layer was formed on the inner surface of the cross tube by the magnetron sputtering method under the conditions of Example 1.

Periodic plasma emission was observed when the non-evaporable getter coating device of Example 1 was used.

FIG. 8 is a photograph, taken by the SEM, of the inner surface of the non-evaporable getter coated cross tube obtained when the test in which the ICF114-standard non-evaporable getter coating device of Example 1 was attached to the ICF114-standard cross tube and the non-evaporable getter material layer was formed on the inner surface of the cross tube by the magnetron sputtering method under the conditions of Example 1 was conducted.

When the non-evaporable getter coating device of Example 1 was used, many crystals with a grain size of 30 nm or less were observed.

FIGS. 9A and 9B are charts that indicate results of XRD measurements on the inner surface of the non-evaporable getter coated cross tube obtained when the test in which the ICF114-standard non-evaporable getter coating device of Example 1 was attached to the ICF114-standard cross tube and the non-evaporable getter material layer was formed on the inner surface of the cross tube by the magnetron sputtering method under the conditions of Example 1 was conducted. FIG. 9A indicates the result of the XRD measurement on the stainless steel sample (Top) for monitoring. FIG. 9B indicates the result of the XRD measurement on the stainless steel sample (Side) for monitoring.

As illustrated in FIGS. 9A and 9B, peaks at 2θ=31° to 43° corresponding to the Ti-Zr-V alloy were observed in both the sample (Top) and the sample (Side), which indicates that the magnetron sputtering produced the non-evaporable getter coating at different positions on the inner surface of the bent-shaped cross tube.

### (Example 2)

An ICF070-standard non-evaporable getter coating device of Example 2 was manufactured by the same operation as in Example 1, except that the materials, dimensions, and the like were as listed in Table 1.

By the same operations as in Example 1, except that the conditions were as listed in Table 1, an electric potential was applied between the sputter target and the cross tube, and observations were made.

The conditions and results for each of the above tests are listed in Table 1.

**[Table 1]**

| | | Unit | Example 2 | Example 1 | Comparative Example 1 |
|---|---|---|---|---|---|
| Flange | Standard/Size | - | ICF070 | ICF114 | ICF114 |
| Sputter target | Type | - | Ti-Zr-V alloy | Ti-Zr-V alloy | Ti-Zr-V alloy |
| | Outer diameter (EDN) | mm | 22.00 | 28.0 | 16.0 |
| | Thickness (TN) | mm | 2.0 | 2.0 | 2.0 |
| Permanent magnet column | Type of permanent magnets | - | Sm-Co magnets | Sm-Co magnets | Sm-Co magnets |
| | Number of permanent magnets | - | 8 | 8 | 9 |
| | Outer diameter (EDM) of permanent magnet | mm | 8.0 | 13.5 | 3.5 |
| | Length (LM) of permanent magnet | mm | 20.0 | 20.0 | 18.0 |
| | Magnetic flux density (at surface of magnet) | Gauss | 3800 | 4200 | 4000 |
| Vacuum container, Vacuum pipe | Standard/Size | - | ICF070 | ICF114 | ICF114 |
| | Inner diameter (INV) | mm | 60.0 | 60.0 | 60.0 |
| | Type | - | Cross tube | Cross tube | Cross tube |
| Shape factors | Ratio (LM/EDM) of length of permanent magnet to outer diameter of permanent magnet | - | 2.5 | 1.5 | 5.1 |
| | Ratio (EDM/EDN) of outer diameter of permanent magnet to outer diameter of sputter target | - | 0.4 | 0.5 | 0.2 |
| Manufacturing conditions | Whether magnetoron sputtering conditions were established | - | Established | Established | Not established |
| | Cathode voltage | V | -600 | -400 | -800 to -1500 |
| | Discharge current | mA | - | 126 | 8 |
| | Input power | w | - | 50 | 6.4 to 9.2 |
| | Pressure of Kr | Pa | 1.5 | 0.5 | 20 to 30 |
| | Maximum electron density | m⁻³ | 3.2×10¹⁵ | 1.2×10¹⁵ | 1×10¹⁴ or less |
| | Magnetic flux density (surface of target) | Gauss | Approximately 250 at maximum | Approximately over 400 at maximum | 200 or less |
| NEG coated vacuum container, vacuum pipe | XRD measurement | - | - | FIG. 9 | - |
| | Thickness of coating | µm | - | 3.0 (Top) | 0.42 |
| | | | | 0.5 (Side) | |
| | Average grain diameter of crystals of coated NEG | nm | - | 50 to 100 | 50 to 100 |
| | Deposition speed | nm/h | - | 500 (Top) | 9 |
| | | | | 80 (Side) | |

In Example 1, in particular, a deposition process in which the magnetic field distribution in the vicinity of the surface of the target was insufficient for plasma confinement and the magnetron sputtering conditions were not established was observed.

In Example 2, in particular, a deposition process in which the magnetic field distribution in the vicinity of the surface of the target was sufficient for plasma confinement and the magnetron sputtering conditions, which were essential for the use of this device, were established was observed.

In Comparative Example 1, a device with preferable geometry factors was not configured, and the magnetron sputtering conditions were not established.

### INDUSTRIAL APPLICABILITY

According to the disclosure, it is possible to provide a non-evaporable getter coating device that can apply non-evaporable getter coating to inner surfaces of vacuum containers or vacuum pipes of various shapes or standards, through the use of the non-evaporable getter coating device being attached to the vacuum containers or vacuum pipes.

The non-evaporable getter coating device according to the disclosure, the method for manufacturing a non-evaporable getter coated container and/or a non-evaporable getter coated pipe using the non-evaporable getter coating device according to the disclosure, and the non-evaporable getter coated container and/or the non-evaporable getter coated pipe that can be manufactured by the manufacturing method are useful in electron microscopes, mass spectrometers, semiconductor manufacturing apparatuses (including the use of vacuum deposition, sputter deposition, molecular beam epitaxy, electron beam/EUV lithography, ion implantation, and the like), apparatuses for manufacturing electronic devices (flat panel displays, imaging elements, solar panels, and the like), vacuum sealed MEMS (accelerometers, gyroscopes, and the like), X-ray generators, PET diagnostic apparatuses, proton beam therapy systems, optical device coating apparatuses, vacuum insulated containers (vacuum bottles, Dewar flasks, and the like), and other devices, and have industrial applicability.

## Claims

1. A non-evaporable getter coating device comprising:
a sputter target having an inner space;
a permanent magnet column provided within a range of the inner space of the sputter target, the permanent magnet column constituted of a plurality of permanent magnets arranged in series with alternate directions of magnetic fields; and
a flange to which the sputter target and the permanent magnet column are secured,
wherein
a ratio (LM/EDM) of a length LM of each of the permanent magnets to an outer diameter EDM of the permanent magnets is 1.0 to 4.0, and
a ratio (EDM/EDN) of the outer diameter EDM of the permanent magnets to an outer diameter EDN of the sputter target is 0.3 to 0.8.

2. The non-evaporable getter coating device according to claim 1, wherein
the sputter target is in shape of a cylinder,
the permanent magnets are in shape of columns, and
the flange is in shape of a disk.

3. The non-evaporable getter coating device according to claim 1 or 2, wherein an extension direction of the sputter target and an extension direction of the permanent magnet column both coincide with a direction perpendicular to a plane of a disk-shaped flange.

4. The non-evaporable getter coating device according to any one of claims 1 to 3, wherein a material of the sputter target includes at least one selected from groups consisting of Ti-Zr-V alloys, Ti-Zr-V-Hf alloys, pure Ti, pure Zr, and pure Pd.

5. The non-evaporable getter coating device according to any one of claims 1 to 4, wherein the permanent magnets include at least one selected from groups consisting of Sm-Co magnets, Nd-Fe-B magnets, Al-Ni-Co magnets, Pr-Co magnets, and ferrite magnets.

6. The non-evaporable getter coating device according to any one of claims 1 to 5, wherein the flange is at least one selected from groups consisting of ICF standard products, NW standard products, ISO standard products, JIS standard products, various metal O-ring sealed products, and various metal gasket sealed products.

7. The non-evaporable getter coating device according to any one of claims 1 to 6, wherein
the length LM of each of the permanent magnets is 5 mm to 100 mm,
the outer diameter EDM of the permanent magnets is 5 mm to 32 mm, and
the outer diameter EDN of the sputter target is 16 mm to 80 mm.

8. The non-evaporable getter coating device according to any one of claims 1 to 7, further comprising a shield provided so as to cover a securing portion between the sputter target and the flange.

9. The non-evaporable getter coating device according to claim 8, wherein a material of the shield includes polyimide resin.

10. The non-evaporable getter coating device according to any one of claims 1 to 9, further comprising a device configured to displace the permanent magnet column to an extension direction.

11. A method for manufacturing a non-evaporable getter coated container and/or a non-evaporable getter coated pipe, the method comprising:
attaching the non-evaporable getter coating device according to claims 1 to 10 to a vacuum pipe and/or a vacuum container; and
forming a non-evaporable getter material layer on an inner surface of the vacuum container and/or the vacuum pipe by a magnetron sputtering method to obtain a non-evaporable getter coated container and/or a non-evaporable getter coated pipe.

12. The method for manufacturing a non-evaporable getter coated container and/or a non-evaporable getter coated pipe according to claim 11, wherein a discharge gas in the magnetron sputtering method is Kr or Ar.

13. The method for manufacturing a non-evaporable getter coated container and/or a non-evaporable getter coated pipe according to claim 11 or 12, wherein a pressure of a discharge gas is 0.05 Pa to 30 Pa.

14. The method for manufacturing a non-evaporable getter coated container and/or a non-evaporable getter coated pipe according to any one of claims 11 to 13, wherein a cathode voltage in the magnetron sputtering method is -1000 V to -300 V.

15. The method for manufacturing a non-evaporable getter coated container and/or a non-evaporable getter coated pipe according to any one of claims 11 to 14, wherein the non-evaporable getter coated pipe and/or the non-evaporable getter coated container is shaped with a bent portion.

16. The method for manufacturing a non-evaporable getter coated container and/or a non-evaporable getter coated pipe according to any one of claims 11 to 15, wherein an inner diameter of the vacuum container and/or the vacuum pipe is 20 mm to 200 mm.

17. A non-evaporable getter coated container and/or a non-evaporable getter coated pipe, comprising a bent portion in shape,
wherein an average grain diameter of crystals of a coated non-evaporable getter is 2 nm to 100 nm.
